(19) **Europäisches Patentamt / European Patent Office / Office européen des brevets**

(11) **EP 1 818 678 B1**

(12) # EUROPÄISCHE PATENTSCHRIFT

(45) Veröffentlichungstag und Bekanntmachung des Hinweises auf die Patenterteilung:
**11.06.2014 Patentblatt 2014/24**

(51) Int Cl.:
***G01R 33/035*** *(2006.01)*

(21) Anmeldenummer: **07001101.0**

(22) Anmeldetag: **19.01.2007**

(54) **Anordnung zur Messung magnetischer Signale**

Assembly for measuring magnetic signals

Agencement de mesure de signaux magnétiques

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **10.02.2006 DE 102006006487**

(43) Veröffentlichungstag der Anmeldung:
**15.08.2007 Patentblatt 2007/33**

(73) Patentinhaber: **Forschungszentrum Jülich GmbH 52425 Jülich (DE)**

(72) Erfinder:
• **Qiu, Longqing**
  **52428 Jülich (DE)**
• **Zhang, Yi**
  **52428 Jülich (DE)**
• **Krause, Hans-Joachim**
  **52499 Baesweiler (DE)**

(56) Entgegenhaltungen:
EP-A- 1 043 597      EP-A2- 0 514 027
WO-A-01/06907      WO-A-97/36186
DE-A1- 19 525 514      GB-A- 2 115 552
US-A- 5 287 059

**Beschreibung**

Die Erfindung betrifft eine Anordnung zur Messung magnetischer Signale.

Aus DE 101 05 796 A1 ist eine Anordnung zum Messen magnetischer Felder, umfassend einen Washer-SQUID oder einem SQUID mit einem single layer flux Transformator sowie einem Ausleseloop bekannt, bei dem zwischen SQUID und Ausleseloop ein Substrat angeordnet ist.

Ein rf-Schwingkreis für den Betrieb eines rf-SQUIDs ist aus Zhang et al. bekannt (Zhang Y. et al., Appl. Phys. Lett. 71 (5), 704-706 und Zhang Y. et al., Applied Superconductivity Vol 6 (7-9), 1998, 385-390).

Die Patentschrift DE19525514 beschreibt eine Anordnung zur Messung magnetischer Wechselfeld-Signale mittels eines Magnetometers, umfassend einen SQUID-Sensor zur Messung der Signale, wobei der SQUID-Sensor des Magnetometers von der Spule mindestens eines LC- Schwingkreises umschlossen wird. Der Störeinfluss von Flussfäden wird so entfernt.

Nachteilig ist die Empfindlichkeit dieser Anordnungen frequenzunabhängig und nicht selektiv erhöht.

Bei manchen Anwendungen in der hochempfindlichen Magnetfeld-Messtechnik, z. B. mittels SQUID, benötigt man einen sehr schmalen Frequenzbereich. Beispiele sind NMR (nuclear magnetic resonance) im niedrigen magnetischen Feld, die Wirbelstromtechnik oder modulierte Messverfahren. Bei diesen Verfahren kommt es darauf an, in einem sehr kleinen Frequenzbereich um die Grundfrequenz (z. B. die Anregungs- oder Modulationsfrequenz) eine möglichst hohe Magnetfeldempfindlichkeit zu erreichen.

Aufgabe der Erfindung ist es, eine Anordnung zur Messung magnetischer Wechselfeldsignale bereit zu stellen, mit welcher in einem engen Frequenzbereich ein Anstieg der Empfindlichkeit durch Erhöhung des Signal-Rausch-Verhältnisses (S/N) gegenüber den aus dem Stand der Technik bekannten Magnetometern erzielt wird.

Die Aufgabe wird durch eine Anordnung gemäß Hauptanspruch gelöst. Vorteilhafte Ausgestaltungen ergeben sich aus den darauf rückbezogenen Patentansprüchen.

Eine Verbesserung der magnetischen Feldempfindlichkeit des Magnetometers wird durch einen LC-Schwingkreis erzielt, der eine Spule mit einer Induktivität L und einen Kondensator der Kapazität C umfasst und der mit seiner Spule den Sensor umschließt.

Dadurch wird vorteilhaft bewirkt, dass das Signal-Rausch-Verhältnis (S/N), im Vergleich zu einer Anordnung ohne einen derartigen Schwingkreis, erheblich verstärkt wird, insbesondere um einen Faktor von mindestens zwei, vorzugsweise um einen Faktor von 10, 15 und mehr.

Der Amplitudengewinn ist dabei größer als der Anstieg des Rauschens im Bereich der Resonanz, so dass netto ein Anstieg des Signal-Rausch-Verhältnisses (S/N) erfolgt.

Die Spule L kann das Magnetometer vorteilhaft direkt umschließen. Der Abstand zwischen dem sensitiven Zentrum des Magnetometers, eines SQUID, und dem Zentrum der Spule ist kleiner als die charakteristische Größe der Spule. Die Normale (Flächenstruktur der Spule) schließt einen genügend kleinen Winkel mit der empfindlichen Richtung des Magnetometers (insbesondere einen Hochtemperatursupraleiter SQUID) ein.

Besonders bevorzugt verlaufen beide Richtungen parallel zueinander, so dass der Winkel 0° beträgt. Die feldempfindlichen Richtungen des Magnetometers bzw. SQUIDs und des Spulen-Normals stehen jedenfalls nicht senkrecht zueinander.

Der induktive Teil L, das heißt die gewickelte Spule des Schwingkreises besteht z. B. aus Kupferdraht. Die Spule L und eine Kapazität C bilden einen Schwingkreis mit einer Resonanz-Frequenz $f_0 = \dfrac{1}{2\pi\sqrt{LC}}$, die für das erwartete Messsignal ausgewählt wird.

Tankschwingkreise gemäß Stand der Technik dienen im Gegensatz hierzu ausschließlich für die induktive Auslese des rf-SQUID-Signals.

Mit anderen Worten, diese sind unabdingbar für den Betrieb eines SQUID. Die Tankschwingkreise gemäß Stand der Technik weisen dabei Resonanzfrequenzen von in der Regel > 20 MHz auf, im Falle eines Substratresonator-Schwingkreises gemäß DE 101 05 796 A1 eine von etwa 500 bis 1000 MHz.

Im Gegensatz hierzu ist der erfindungsgemäße LC-Schwingkreis nicht zwingend notwendig für den SQUID-Betrieb. Die erfindungsgemäße Vorrichtung bewirkt vielmehr besonders vorteilhaft, dass das Signal-Rausch-Verhältnis bei einer ausgewählten Frequenz erhöht wird. Diese Frequenz liegt typischerweise zwischen 5 kHz und 10 MHz. Der erfindungsgemäße LC-Schwingkreis weist darüber hinaus einen positiven Einfluss auf die Messung eines Signals fester Frequenz für alle Magnetometer auf, nicht nur für einen Hochtemperatursupraleiter-SQUID.

Der resultierende Netto-Gewinn beim Signal-Rausch-Verhältnis(S/N) hängt von den resonanten Frequenzen und der Anzahl (n) der Windungen der Spule des LC-Schwingkreises ab.

Im Weiteren wird die Erfindung an Hand von Ausführungsbeispielen und den beigefügten Figuren näher beschrieben.

Es zeigen:

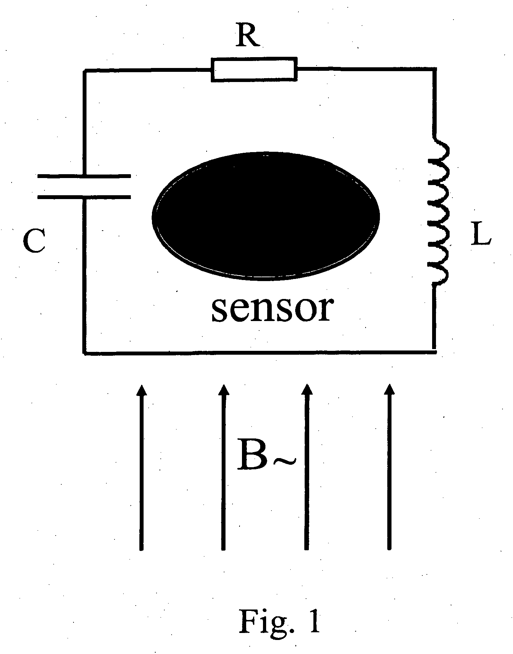

Fig. 1.   Erfindungsgemäße Anordnung aus Schwingkreis und Sensor.

Fig. 2.   Erfindungsgemäße Anordnung aus Schwingkreis mit Spule L und Sensor, umfassend einen SQUID, in einem Dewar mit flüssigem $N_2$.

Fig. 3.     Abhängigkeit der Feldempfindlichkeit von der Frequenz.

a) Signal-Rausch-Verhältnis (S/N) mit Anordnung gemäß Stand der Technik.
b) Signal-Rausch-Verhältnis (S/N) mit erfindungsgemäßer Anordnung mit resonantem Schwingkreis.

Fig.4.     Netto-Gewinn für verschiedene Spulen L mit n=100 bis n=500 mit verschiedenen Resonanzfrequenzen $f_0$.

Fig. 5.     Darstellung der Resonanzverbreiterung durch eine Anordnung umfassend zwei resonante Schwingkreise mit unterschiedlichen Resonanzfrequenzen.

a) Aufbau der Anordnung.
b) Abhängigkeit der Feldempfindlichkeit von der Frequenz.

In den Figuren und den zugehörigen Messungen wurde ein Substrat-Resonator wie aus DE 101 05 796 A1 bekannt, als rf-Schwingkreis Sensor für die rf-SQUID Operation verwendet. Die Empfindlichkeit des rf-SQUIDs betrug bei einer "pick-up-Fläche" von 1 cm$^2$ etwa 40 fT/√Hz, die innerhalb der Ausgangs-Bandbreite von der Frequenz unabhängig z. B. von DC bis 1 MHz ist.

Fig.l zeigt einen Sensor und einen diesen umschließenden LC-Schwingkreis. Der LC-Schwingkreis bewirkt besonders vorteilhaft die resonante Erhöhung der Feldempfindlichkeit des Magnetometers. Die Spule L umschließt den Sensor. Das heißt, dass der Sensor im Zentrum der Spule angeordnet ist, so dass die Spule L den Sensor direkt umschließt. Der Abstand zwischen dem sensitiven Zentrum des Sensors, vorzugsweise eines SQUID, und dem Zentrum der Spule ist kleiner gewählt als die charakteristische Größe der Spule. Die Normale (Flächenstruktur der Spule) und die empfindliche Richtung des Sensors schließen einen Winkel von 0° ein.

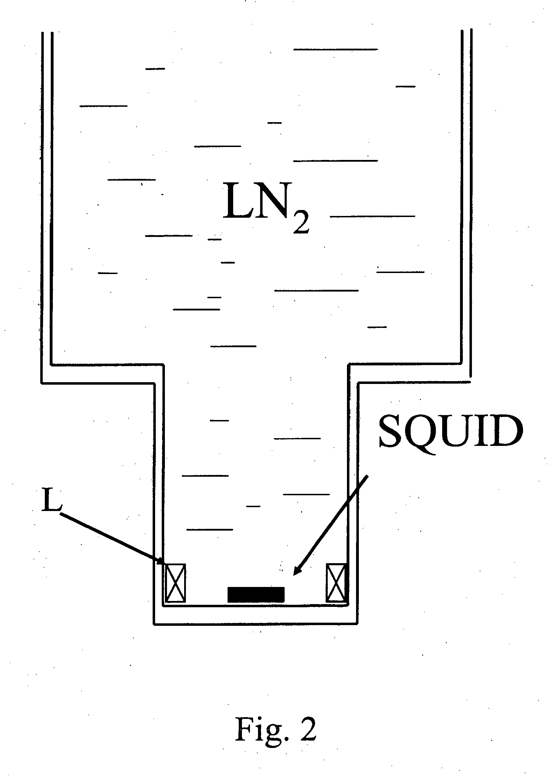

Fig. 2 zeigt eine erfindungsgemäße Anordnung in einem Dewar in flüssigem Stickstoff (LN$_2$) zur SQUID-Kühlung derart, dass die Spule des LC-Schwingkreises den SQUID umschließt. Sowohl die Spule L als auch der SQUID sind vorteilhaft im flüssigen N$_2$ angeordnet.

Der Schwingkreis gemäß Fig. 2 umfasst Kondensatoren zur Erzeugung unterschiedlicher Frequenzen (nicht dargestellt). Der Schwingkreis mit Spule L sorgt dafür, dass der SQUID ein magnetisches Wechselfeld einer unterhalb des SQUID angeordneten Probe (nicht dargestellt) der Frequenz $f_0$ auf zwei verschiedene Arten detektieren kann:

1. Der SQUID-Sensor misst das magnetische Wechselfeld der Probe direkt.

2. Durch ein magnetisches Wechselfeld wird ein Wechselstrom $i$ mit der gleichen Frequenz $f_0$ wie die der Probe in dem Schwingkreis induziert. Der Strom $i$ lässt sich folgendermaßen ausdrücken:

$$i = -\frac{QL}{R} \cdot \frac{\partial \Phi}{\partial t}$$

Dabei bezeichnet $Q$ die Güte des Schwingkreises und $\phi$ den zu messenden magnetischen Fluss. Dieser Strom $i$ erzeugt durch die Gegeninduktivität $M$ zwischen der Spule $L$ und der Induktivität des SQUIDs $L_s$ einen zusätzlichen magnetischen Fluss $\phi_{zu}$.

Der Schwingkreis bringt auch ein zusätzliches Fluss-Rauschen $\phi_{rau}$. Falls $\phi_{zu} > \phi_{rau}$ ist, wird das Signal-zu-Rauschen-Verhältnis (SNR) bei der Messung des externen Magnetfeldes verbessert.

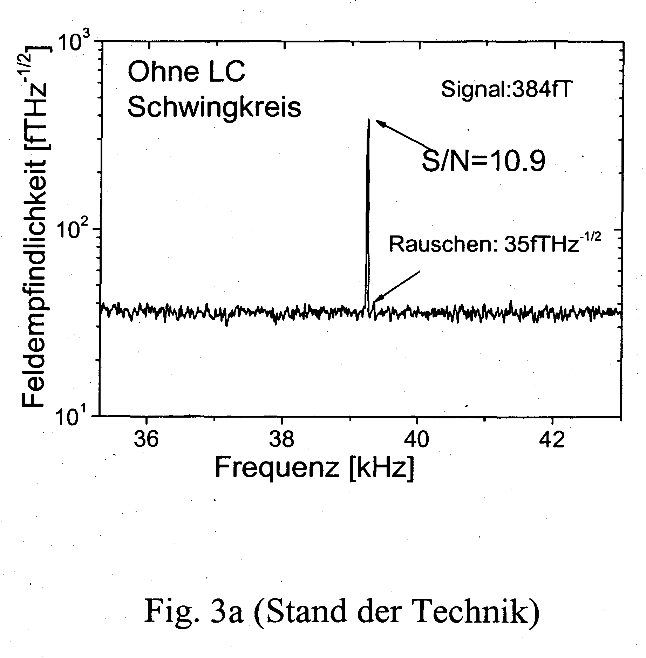

In Fig. 3a) ist mit der Anordnung nach Stand der Technik ein S/N-Verhältnis von 10,9 ermittelt worden. Das zu messende Signal ist als Peak aus dem Rauschen herausgehoben.

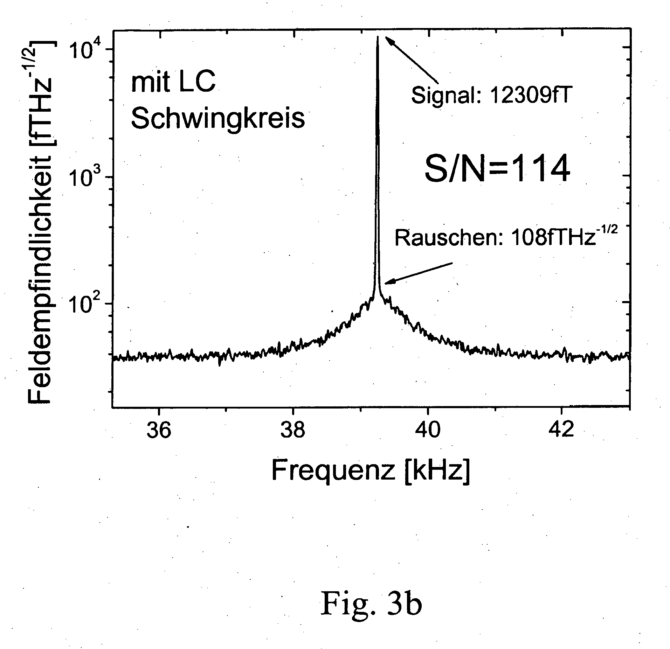

In Fig. 3b) ist die Verstärkung der Signalamplitude mit der erfindungsgemäßen Anordnung wiedergegeben. Die zu messende Signalamplitude ist resonant verstärkt. Der Amplitudengewinn ist viel größer als der Anstieg des Rauschens im Bereich der Resonanz (S/N=114). Netto bleibt ein Anstieg des Signal-Rausch-Verhältnisses (S/N) um etwa einen Faktor von 10 gegenüber der in Fig. 3a) gezeigten Ergebnisse. Somit ist mit der erfindungsgemäßen Anordnung eine deutliche Verbesserung des Signal-Rausch-Verhältnisses des SQUID erzielt worden.

Im dargestellten Fall betrug die Kapazität $C$ = 4,7 nF, die Spule wies 200 Windungen bei einem Durchmesser von 4,8 cm auf. Der Drahtdurchmesser betrug 0,12 mm. Es ergab sich eine Resonanzfrequenz des Schwingkreises von 39,4 kHz. Der Faktor in Bezug auf den resultierenden gemessenen Netto-Gewinn beim Signal-Rausch-Verhältnis (S/N) betrug 10,4.

Der resultierende Netto-Gewinn beim Signal-Rausch-Verhältnis(S/N) hängt von den resonanten Frequenzen und der Anzahl (n) der Windungen der Spule des LC Schwingkreises ab.

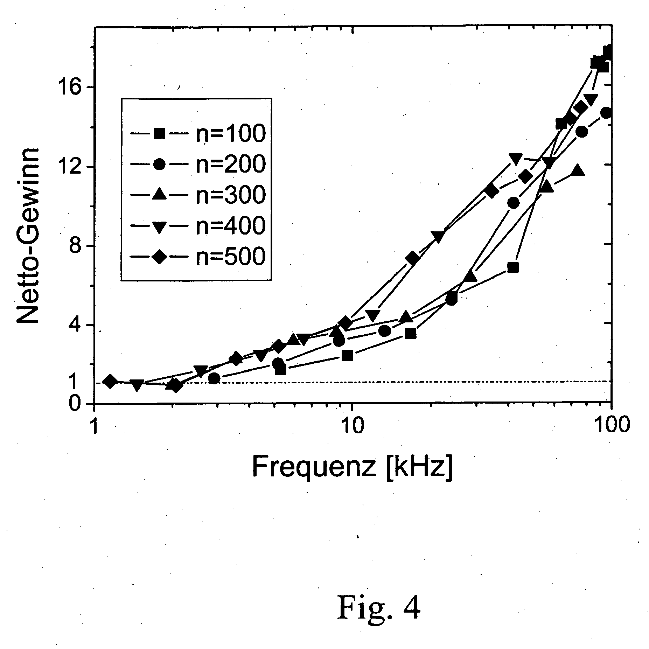

In Fig. 4 ist der gemessene Netto-Gewinn im Signal-Rausch-Verhältnis unter verschiedenen Bedingungen dargestellt. Verwendet wurde eine den SQUID umschließende Spule des Durchmessers 4,8 cm mit 100, 200, 300, 400 oder 500 Windungen. Der Drahtdurchmesser betrug 0,12 mm. Durch unterschiedliche Wahl der Kapazität C des Schwingkreises wurde die Resonanzfrequenz zwischen 1 kHz und 100 kHz variiert. Das Signal-Rausch-Verhältnis wurde mit einem Spektrumanalysator (HP 3562 A) gemessen.

Bei den Messergebnissen zu den Fig. 3 bis Fig. 5 wurde der SQUID /Sensor mit einem Anregungssignal mit konstanter Amplitude bei der Resonanzfrequenz unter Verwendung einer großen Anregungsspule (drei Windungen, Durchmesser *D* = 8,5 cm) beaufschlagt. Da die Anregungsspule ein quasi homogenes Feld erzeugt, kalibriert man die Empfindlichkeit des Systems hiermit.

Aufgetragen wurde der Gewinn im Signal-Rausch-Verhältnis mit resonantem Schwingkreis im Vergleich zur Situation ohne Schwingkreis. Man erkennt, dass der erreichbare Gewinn durch den resonanten Schwingkreis mit wachsender Frequenz größer wird.

Durch die Verwendung mehrerer unabhängiger Schwingkreise *n* mit leicht verschiedenen Resonanzfrequenzen $f_i$, i∈1...n, ist es möglich, die Resonanz zu verbreitern.

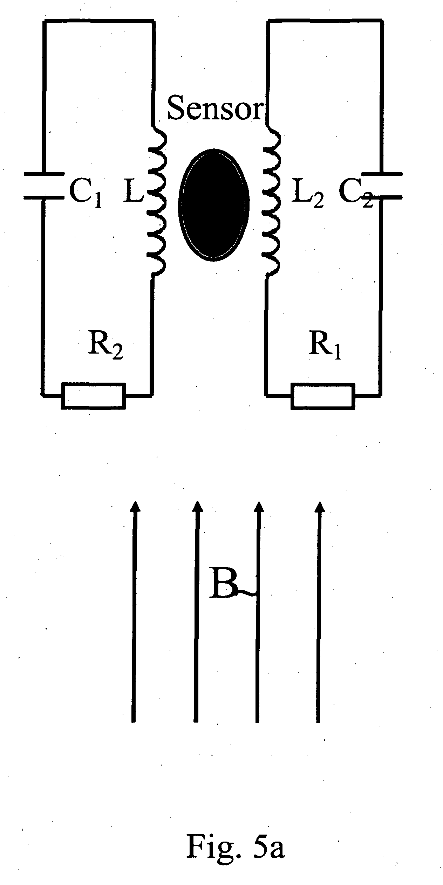

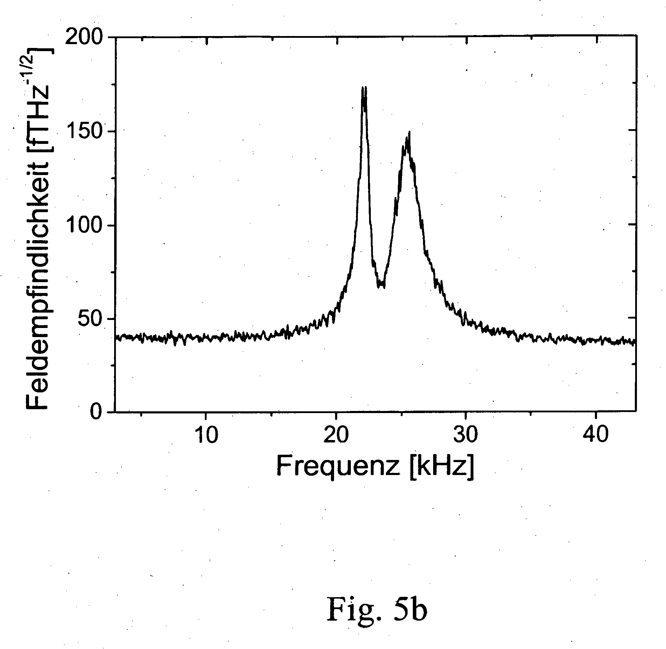

Fig. 5 zeigt dies schematisch für den Fall zweier Schwingkreise (D-Spulen), die den SQUID umschließen (Fig. 5a). Die sich ergebende Resonanzverbreiterung im Falle eines Frequenzabstandes, der etwa der Resonanzbreite entspricht

$$\Delta f = f_2 - f_1 \approx \frac{f_1 + f_2}{2} \cdot \frac{1}{Q} \quad ,$$

ist in Fig. 5b) wiedergegeben. Der Messbereich der Frequenz ist vergrößert.

Die zwei LC-Schwingkreise gemäß Fig. 5 sind unabhängig und zum SQUID separat gekoppelt. Die Gegeninduktivität zwischen den beiden Schwingkreisen ist minimiert.

Die erfindungsgemäße Anordnung zur Steigerung der Empfindlichkeit ist sowohl für rf- als auch für dc-SQUIDs geeignet.

Ohne Einschränkung der Erfindung ist die Verwendung einer erfindungsgemäßen Anordnung umfassend einen resonanten Schwingkreis auch auf andere Messanordnungen übertragbar, z. B. auf Hall-Sonden oder GMR-Sensoranordnungen, die auf dem Prinzip des sogenannten Riesenmagnetowiderstandes (giant magneto resistance) beruhen.

**Patentansprüche**

1. Anordnung zur Messung magnetischer Wechselfeld-Signale mittels eines Magnetometers, umfassend einen SQUID-Sensor zur Messung der Signale, wobei der SQUID-Sensor des Magnetometers von der Spule (L) mindestens eines LC-Schwingkreises umschlossen wird,
   **dadurch gekennzeichnet, dass**
   die Resonanzfrequenz des LC-Schwingkreis zur Erhöhung des Signal-Rausch-Verhältnisses des SQUID-Sensors zwischen 5 kHz und 10 MHz liegt und mit der zu messenden Frequenz übereinstimmt.

2. Anordnung nach Anspruch 1,
   **dadurch gekennzeichnet, dass**
   der Schwingkreis induktiv mit dem Sensor koppelt.

3. Anordnung nach einem der vorhergehenden Ansprüche,
   **gekennzeichnet durch**
   Kupfer als Material der Spule des zusätzlichen Schwingkreises.

4. Anordnung nach einem der vorherigen Ansprüche,
   **dadurch gekennzeichnet, dass**
   diese durch ein magnetisches Wechselfeld einen Wechselstrom i mit der gleichen Frequenz $f_0$ wie das der Probe in dem Schwingkreis zu induzieren vermag.

5. Anordnung nach einem der vorhergehenden Ansprüche,
   **gekennzeichnet durch**
   mehrere den Sensor umschließende LC-Schwingkreise mit verschiedenen Resonanzfrequenzen.

6. Anordnung nach einem der vorhergehenden Ansprüche,
   **dadurch gekennzeichnet, dass**
   das Magnetometer einen HTSL-SQUID oder eine Hall-Sonde oder eine GMR-Sensoranordnung umfasst.

7. Anordnung nach einem der vorhergehenden Ansprüche,
   **dadurch gekennzeichnet, dass**
   die Spule (L) des Schwingkreises zusammen mit dem Sensor in einem Dewar in gekühltem $N_2$ angeordnet ist.

8. Verfahren zur Messung magnetischer Wechselfeld-Signale mittels eines Magnetometers, umfassend einen SQUID-Sensor zur Messung der Signale, wobei der SQUID-Sensor des Magnetometers von der Spule (L) mindestens eines LC-Schwingkreises umschlossen wird,
   **gekennzeichnet durch**
   Wahl einer Resonanzfrequenz für den LC-Schwingkreis zwischen 5 kHz und 10 MHz, welche mit der zu messenden Frequenz übereinstimmt.

**Claims**

1. Arrangement for measuring magnetic alternating field signals by means of a magnetometer, comprising a SQUID sensor for measuring signals, in which the SQUID sensor of the magnetometer is surrounded by the coil (L) of at least one LC resonant circuit,
   **characterised in that**
   the resonance frequency of the LC resonant circuit for increasing the signal to noise ratio of the SQUID sensor is between 5 kHz and 10 MHz and is in line with the frequency to be measured.

2. Arrangement according to claim 1,
   **characterised in that**
   the resonant circuit is connected to the sensor inductively.

3. Arrangement according to one of the previous claims,
   **characterised by**
   copper as the material for the coil of the additional resonant circuit.

4. Arrangement according to one of the previous claims,
   **characterised in that**
   this may be induced by a magnetic alternating field of an alternating current i with the same frequency $f_0$ as that of the sample in the resonant circuit.

5. Arrangement according to one of the previous claims,
   **characterised by**
   several LC resonant circuits with various resonance frequencies surrounding the sensor.

6. Arrangement according to one of the previous claims,
   **characterised in that**
   the magnetometer comprises an HTSL-SQUID or a Hall probe or a GMR sensor arrangement.

7. Arrangement according to one of the previous claims,
   **characterised in that**
   the coil (L) of the resonant circuit is arranged together with the sensor in a Dewar in cooled $N_2$.

8. Method for measuring magnetic alternating field signals by means of a magnetometer, comprising a SQUID sensor for measuring the signals, in which the SQUID sensor of the magnetometer is surrounded by the coil (L) of at least one LC resonant circuit,
   **characterised by**
   the choice of a resonance frequency for the LC resonant circuit between 5 kHz and 10 MHz, which is in line with the frequency to be measured.

**Revendications**

1. Agencement de mesure de signaux magnétiques de champ alternatif au moyen d'un magnétomètre, comprenant un capteur SQUID servant à la mesure des signaux, le capteur SQUID du magnétomètre étant entouré par la bobine (L) d'au moins un circuit d'oscillation LC,
   **caractérisé en ce que**
   la fréquence de résonance du circuit d'oscillation LC est située entre 5 kHz et 10 MHz pour augmenter le rapport signal sur bruit du capteur SQUID et coïncide avec la fréquence à mesurer.

2. Agencement selon la revendication 1,
   **caractérisé en ce que**
   le circuit d'oscillation est couplé par induction au capteur.

3. Agencement selon l'une quelconque des revendications précédentes,
   **caractérisé en ce que**
   le matériau de la bobine du circuit d'oscillation supplémentaire est du cuivre.

4. Agencement selon l'une quelconque des revendications précédentes,
   **caractérisé en ce que**
   cet agencement est capable d'induire par un champ magnétique alternatif un courant alternatif i ayant la même fréquence $f_0$ que celui de l'échantillon dans le circuit d'oscillation.

5. Agencement selon l'une quelconque des revendications précédentes,
   **caractérisé en ce que**
   plusieurs circuits d'oscillation LC avec différentes fréquences de résonance entourent le capteur.

6. Agencement selon l'une quelconque des revendications précédentes,
   **caractérisé en ce que**
   le magnétomètre comprend un capteur HTSL-SQUID ou une sonde de Hall ou un agencement de capteur GMR.

7. Agencement selon l'une quelconque des revendications précédentes,
   **caractérisé en ce que**
   la bobine (L) du circuit d'oscillation est disposée conjointement avec le capteur dans un vase de Dewar dans de l'azote $N_2$ refroidi.

8. Procédé de mesure de signaux magnétiques de champ alternatif au moyen d'un magnétomètre, comportant un capteur SQUID pour la mesure des signaux, le capteur SQUID du magnétomètre étant entouré par la bobine (L) d'au moins un circuit d'oscillation LC,
   **caractérisé par**
   le choix d'une fréquence de résonance pour le circuit d'oscillation LC entre 5 kHz et 10 MHz, laquelle fréquence coïncidant avec la fréquence à mesurer.

Fig. 1

LN$_2$

SQUID

L

Fig. 2

Fig. 3a (Stand der Technik)

Fig. 3b

Fig. 4

Fig. 5a

Fig. 5b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10105796 A1

- DE 19525514

**In der Beschreibung aufgeführte Nicht-Patentliteratur**

- **ZHANG Y. et al.** *Appl. Phys. Lett.,* vol. 71 (5), 704-706

- **ZHANG Y. et al.** *Applied Superconductivity,* 1998, vol. 6 (7-9), 385-390